# EUROPEAN PATENT APPLICATION

(11) **EP 3 319 131 A1**
(43) Date of publication of application: **09.05.2018**
(21) Application number: 17199653.1
(22) Date of filing: 02.11.2017
(51) Int. Cl.: H01L 31/049, H01L 31/048, H01L 31/068

(54) **SOLAR CELL PANEL AND BACK SHEET FOR THE SAME**

(30) Priority: 04.11.2016 KR 20160146729
(71) Applicant: LG Electronics Inc., SEOUL, 07336 (KR)
(72) Inventor: KIM, Byongsu, 08592 Seoul (KR); KIM, Juseok, 08592 Seoul (KR); PARK, Sanghwan, 08592 Seoul (KR); CHANG, Sungho, 08592 Seoul (KR)
(74) Representative: Frenkel, Matthias Alexander

(57) **Abstract**

Disclosed is a solar cell panel including a bi-facial solar cell; a front portion positioned on a front surface of the bi-facial solar cell; and a rear portion positioned on a back surface of the bi-facial solar cell, wherein the rear portion has transmittance to ultraviolet light.

## Description

### CROSS-REFERENCE TO RELATED APPLICATION

This application claims priority to and the benefit of Korean Patent Application No. 10-2016-0146729, filed in the Korean Intellectual Property Office on November 4, 2016, the entire contents of which are incorporated herein by reference.

### ACKNOWLEDGMENTS

This work was supported by the Korea Institute of Energy Technology Evaluation and Planning (KETEP) and the Ministry of Trade, Industry & Energy (MOTIE) of the Republic of Korea (No. 20163010012430).

### BACKGROUND OF THE INVENTION

### (a) Field of the Invention

Embodiments of the invention relate to a solar cell panel and a back sheet for the same, and, more particularly, to a solar cell panel including a bi-facial solar cell and a back sheet for the same.

### (b) Description of the Related Art

Recently, as existing energy resources such as petroleum and coal are expected to be depleted, interest in alternative energy to replace them is increasing. Among them, solar cells are attracting attention as a next-generation battery that converts solar energy into electric energy.

Since a solar cell is exposed to an outer environment for a long time, the solar cell is packaged through a packaging process for protecting the solar cell, thereby forming a solar cell panel. Because solar cell panels must generate electricity in various environments, solar cell panels require long-term reliability so that they generate electricity for a long time in various environments.

Meanwhile, in order to prevent problems such as deterioration due to ultraviolet light, a solar cell panel may include an ultraviolet screening agent on a rear portion of the solar panel or a rear portion of the solar panel may be formed of a material having little optical transparency, thereby reflecting or blocking the light. When a solar cell having a bi-facial solar cell in which light is received on both sides of a solar cell is applied to the solar cell panel, it is difficult to utilize light or ultraviolet light incident on the back surface for photoelectric conversion.

### SUMMARY OF THE INVENTION

Embodiments of the invention have been made in view of the above problems and provide a solar cell panel and a back sheet for the same that can enhance efficiency and output.

A solar cell panel according to an embodiment of the invention includes a bi-facial solar cell; a front portion positioned on a front surface of the bi-facial solar cell; and a rear portion positioned on a back surface of the bi-facial solar cell, wherein the rear portion has transmittance to ultraviolet light.

A back sheet for a solar cell panel according to an embodiment of the invention includes a resin, wherein the back sheet has transmittance to ultraviolet light.

In the embodiment, a rear portion has transmittance to ultraviolet light, and the ultraviolet light incident on a back surface of a solar cell can be used for photoelectric conversion when the solar cell has a bi-facial structure. Thereby, the rear portion does not include an ultraviolet blocking agent. Instead, at least one of a plurality of layers constituting the rear portion includes an ultraviolet stabilizer to minimize or prevent problems caused by ultraviolet light.

### BRIEF DESCRIPTION OF THE DRAWINGS

The above and other objects, features and other advantages of the invention will be more clearly understood from the following detailed description taken in conjunction with the accompanying drawings, in which:
FIG. 1 is a schematic exploded perspective view of a solar cell panel according to an embodiment of the invention;
FIG. 2 is a cross-sectional view taken along line II-II in FIG. 1;
FIG. 3 is a cross-sectional view of a solar cell according to an embodiment of the invention;
FIG. 4 is a front plan view of the solar cell shown in FIG. 3;
FIG. 5 is a graph showing a relative value of intensity of a solar spectrum according to a wavelength of light;
FIG. 6 is a graph showing a quantum efficiency of a solar cell according to a wavelength of light.
FIG. 7 is a partial expended view of a part of a solar cell panel according to another embodiment of the invention;
FIG. 8 is a partial expended view of a part of a solar cell panel according to yet another embodiment of the invention;
FIG. 9 is a partial expended view of a part of a solar cell panel according to yet still another embodiment of the invention;
FIG. 10 is a partial expended view of a part of a solar cell panel according to yet still another embodiment of the invention;
FIG. 11 is a partial expended view of a part of a solar cell panel according to yet still another embodiment of the invention; and
FIG. 12 is a graph showing transmittance of a rear portion according to Embodiment 1 and Comparative Example 1.

### DETAILED DESCRIPTION OF THE EMBODIMENTS

Reference will now be made in detail to various embodiments of the invention, examples of which are illustrated in accompanying drawings. The invention may, however, be embodied in many alternate forms and should not be construed as limited to the embodiments set forth herein.

In the drawings, illustration of parts unrelated to embodiments of the invention is omitted for clarity and simplicity of description. The same reference numerals designate the same or very similar elements throughout the specification. In the drawings, the thicknesses, widths or the like of elements are exaggerated or reduced for clarity of description, and should not be construed as limited to those illustrated in the drawings.

It will be understood that the terms "comprises" and/or "comprising," or "includes" and/or "including" used in the specification specify the presence of stated elements, but do not preclude the presence or addition of one or more other elements. In addition, it will be understood that, when an element such as a layer, film, region, or plate is referred to as being "on" another element, it may be directly disposed on another element or may be disposed such that an intervening element is also present therebetween. Accordingly, when an element such as a layer, film, region, or plate is disposed "directly on" another element, this means that there is no intervening element between the elements.

Hereinafter, a solar cell panel and a back sheet for the same according to an embodiment of the invention will be described in detail with reference to the accompanying drawings.

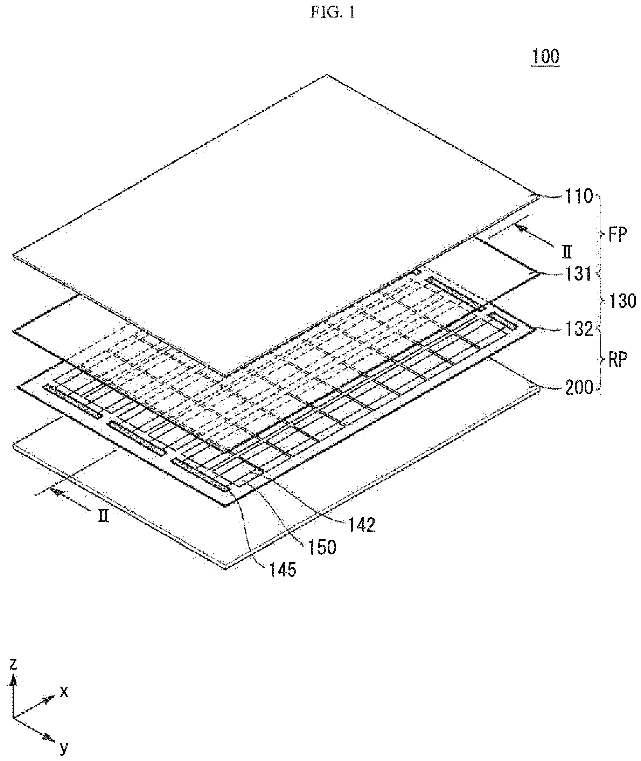

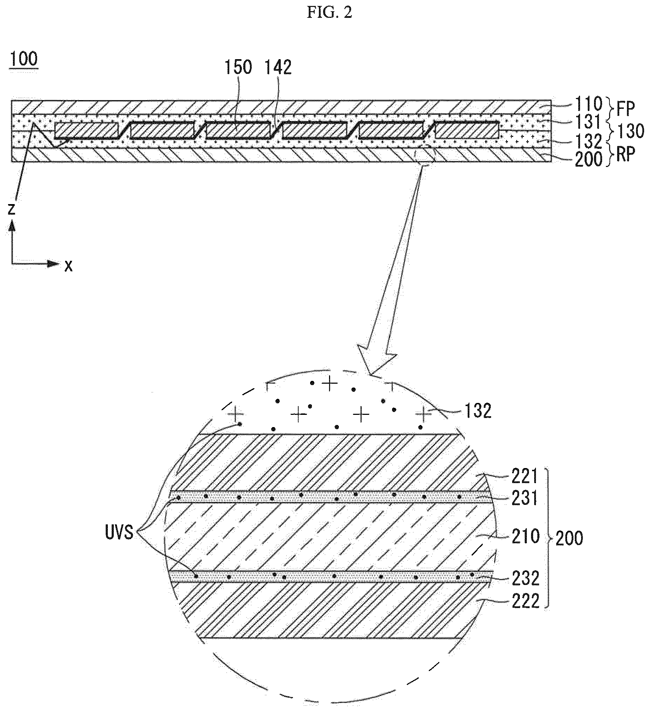

FIG. 1 is a schematic exploded perspective view of a solar cell panel according to an embodiment of the invention, and FIG. 2 is a cross-sectional view taken along line II-II in FIG. 1.

Referring to FIGS. 1 and 2, a solar cell panel 100 according to an embodiment includes a solar cell 150 having a bi-facial structure, a front portion FP positioned on a front surface of the solar cell 150, and a rear portion RP positioned on a back surface of the solar cell 150. The rear portion RP has transmittance to ultraviolet light. The front portion FP may have transmittance to ultraviolet light. The front portion FP may include a front member 110 positioned on the front surface of the solar cell 150 and a first sealing member 131 disposed between the solar cell 150 and the front member 110. The rear portion RP may include a rear member (or a back member) 200 positioned on the back surface of the solar cell 150 and a second sealing member 132 positioned between the solar cell 150 and the rear member 200. This will be described in more detail.

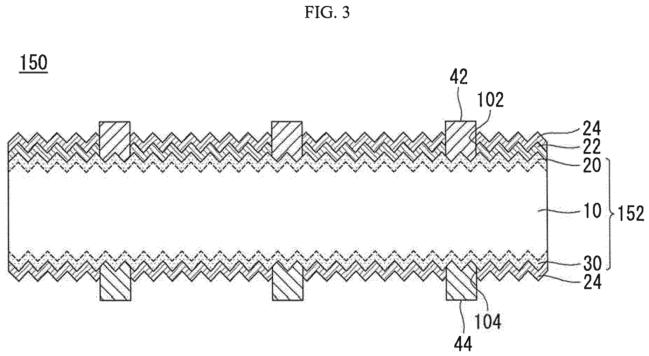

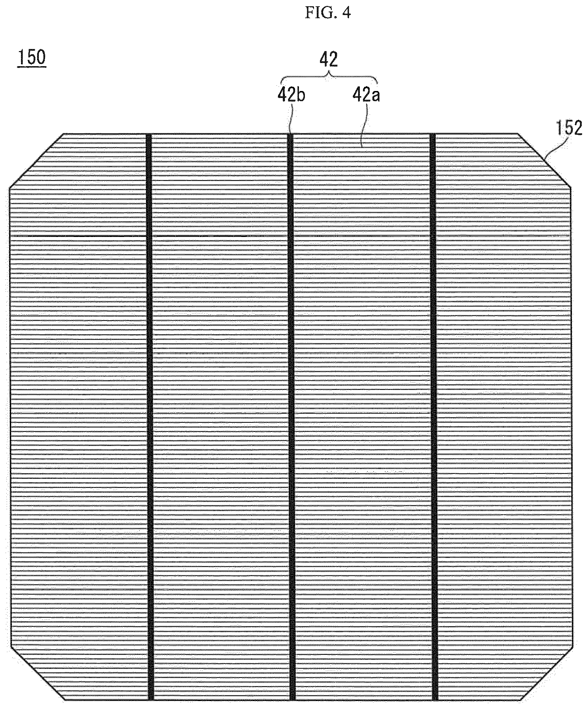

First, the solar cell 150 may include a photoelectric conversion unit that converts solar energy into electric energy, and an electrode electrically connected to the photoelectric conversion unit and collects and delivers current. In the embodiment, a photoelectric conversion unit including a semiconductor substrate (for example, a silicon wafer) and a conductivity type region may be applied as an example. In this instance, the solar cell 150 may have a bi-facial structure in which light can be received on both sides of the semiconductor substrate. An example of the solar cell 150 having a bi-facial structure will be described in detail with reference to FIGS. 3 and 4, and then, the solar cell panel 100 will be described in detail with reference to FIG. 1 and FIG. 2 again.

FIG. 3 is a cross-sectional view of the solar cell 150 according to an embodiment of the invention, and FIG. 4 is a front plan view of the solar cell 150 shown in FIG. 3.

In the embodiment, the solar cell 150 includes a semiconductor substrate 152, a conductivity type region 20 or 30 formed on or formed at the semiconductor substrate 152, and an electrode 42 and 44 connected to the conductivity type region 20 or 30. In this instance, the conductivity type region 20 or 30 may include a first conductivity type region 20 and a second conductivity type region 30 having different conductivity types from each other. The electrode 42 or 44 may include a first electrode 42 connected to the first conductivity type region 20, and a second electrode 44 connected to the second conductivity type region 30. This will be described in more detail.

The semiconductor substrate 152 may include a base region 10 having a first or second conductivity type. The base region 10 includes a first or second conductivity type dopant with a relatively low doping concentration. As an example, the base region 10 may have a second conductivity type. The base region 10 may be comprised of a single crystalline semiconductor (e.g., a single-crystalline or polycrystalline semiconductor of a single material, e.g., single-crystalline or polycrystalline silicon, particularly, single-crystalline silicon) including a first or second conductivity type dopant. The solar cell 150 based on the base region 10 or the semiconductor substrate 152 having a high degree of crystallinity and having few defects is excellent in electrical characteristics.

An anti-reflection structure capable of minimizing reflection may be formed at the front surface and the back surface of the semiconductor substrate 152. For example, a texturing structure having a concavo-convex shape in the form of a pyramid or the like may be provided as the anti-reflection structure. The texturing structure formed at the semiconductor substrate 152 may have a certain shape (e.g., a pyramid shape) having an outer surface formed along a specific crystal plane (e.g., (111) plane) of the semiconductor. When the surface roughness of the semiconductor substrate 152 is increased due to the unevenness formed at the front surface of the semiconductor substrate 152 by such texturing, the reflectance of the light incident into the semiconductor substrate 152 can be reduced to minimize the optical loss. However, the embodiments of the invention are not limited thereto, and the texturing structure may be formed at only one surface of the semiconductor substrate 152, or the texturing structure may not be formed at the front and back sides of the semiconductor substrate 152.

The first conductivity type region 20 having the first conductivity type may be formed at one surface (e.g., the front surface) of the semiconductor substrate 152. The second conductivity type region 30 having the second conductivity type may be formed at the other surface (e.g., the back surface) of the semiconductor substrate 152. The first or second conductivity type regions 20 or 30 may have a different conductivity type than the base region 10 or may have a higher doping concentration than the base region 10 in the instance that the first or second conductivity type regions 20 or 30 has the conductivity type the same as the conductivity type of the base region 10.

In the embodiment, each of the first and second conductivity type regions 20 and 30 may be constituted by a doped region constituting a part of the semiconductor substrate 152. In this instance, the first conductivity type region 20 may be composed of a crystalline semiconductor (e.g., a single-crystalline or polycrystalline semiconductor, for example, a single-crystalline or polycrystalline silicon, particularly, a single-crystalline silicon) including the first conductive type dopant. The second conductivity type region 30 may be composed of a crystalline semiconductor (e.g., a single-crystalline or polycrystalline semiconductor, for example, a single-crystalline or polycrystalline silicon, particularly, a single-crystalline silicon) including the second conductivity type dopant. As described above, when each of the first and second conductivity type regions 20 and 30 constitute a part of the semiconductor substrate 152, junction characteristics with the base region 110 can be improved.

In the drawings, it is exemplified that each of the first and second conductivity type regions 20 and 30 has a homogeneous structure formed at an entire portion in a plan view and having a uniform doping concentration. In this instance, the first and second conductivity type regions 20 and 30 can be formed to have a sufficient area and can be manufactured by a simple process. However, the embodiments of the invention are not limited thereto. Thus, the first conductivity type region 20 may have the homogeneous structure or a selective structure, and the second conductivity type region 30 may have the homogeneous structure, a selective structure, or a local structure. In the selective structure, a portion of the first or second conductivity type region 20 or 30 adjacent to the first or second electrode 42 or 44 has a high doping concentration, a large junction depth, and/or a low resistance, and the other portion of the first or second conductivity type region 20 or 30 has a low doping concentration, a small junction depth, and/or high resistance. In the selective structure, a contact resistance with the first or second electrode 42, 44 can be reduced, and a recombination characteristic can be improved. In the local structure, the second conductivity type region 30 may be formed locally only at a portion where the second electrode 44 is located. In the local structure, short-circuit current (Jsc) and open-circuit voltage can be improved by minimizing an area of the second conductivity type region 30 to reduce recombination. Various other structures may be applied.

Alternatively, the embodiments of the invention are not limited thereto, and at least one of the first and second conductivity type regions 20 and 30 may be formed separately from the semiconductor substrate 152 on the semiconductor substrate 152. In this instance, the first or second conductivity type regions 20 or 30 may be formed of a semiconductor layer (e.g., an amorphous semiconductor layer, a micro-crystalline semiconductor layer, or a polycrystalline semiconductor layer, for example, an amorphous silicon layer, a micro-crystalline silicon layer, or a polycrystalline silicon layer) having a crystal structure different from that of the semiconductor substrate 152 so that the first or second conductivity type regions 20 or 30 can be easily formed on the semiconductor substrate 152. In this instance, a separate layer (a tunneling layer, a passivation layer, etc.) may be formed between the first and second conductivity type regions 20 and 30 and the semiconductor substrate 152.

One of the first and second conductivity type regions 20 and 30, which has a conductivity type different from that of the base region 10, constitutes at least a part of the emitter region. The emitter region forms a pn junction with the base region 10 to produce a carrier by photoelectric conversion. The other of the first and second conductivity type regions 20 and 30 having the same conductivity type as the base region 10 constitutes at least a part of a surface field region. The surface field region forms an electric field that prevents or reduces carriers from being lost by recombination on the surface of the semiconductor substrate 152. For example, in the embodiment, the base region 10 has the second conductivity type, the first conductivity type region 20 constitutes the emitter region, and the second conductivity type region 30 constitutes a back surface field region. However, the embodiments of the invention are not limited thereto.

In the embodiment, various materials having an n-type or a p-type may be used as the first or second conductivity type dopant. As the p-type dopant, a group 3 element such as boron (B), aluminum (Al), gallium (Ga), or indium (In) may be used. As the n-type dopant, a group 5 element such as phosphorus (P), arsenic (As), bismuth (Bi) and antimony (Sb) can be used. For example, the p-type dopant may be boron (B) and the n-type dopant may be phosphorus (P).

For example, in the embodiment, the base region 10 and the second conductivity type region 30 may have an n-type and the first conductivity type region 20 may have a p-type. Then, the base region 10 and the first conductivity type region 20 form a pn junction. When light is incident to the pn junction, electrons generated by the photoelectric effect move toward the back surface of the semiconductor substrate 152 and are collected by the second electrode 44, and the holes move toward the front surface of the semiconductor substrate 152 and collected by the first electrode 42. Thereby, electric energy is generated. Then, the holes having a low moving speed than electrons may move to the front surface of the semiconductor substrate 152, thereby improving the efficiency. However, the embodiments of the invention are not limited thereto. Thus, the base region 10 and the second conductivity type region 30 may have a p-type and the first conductivity type region 20 may have an n-type.

A first insulating layer such as a first passivation layer 22 and an anti-reflection layer 24 may be formed on at least a front surface of the semiconductor substrate 152 (more particularly, on at least the first conductivity type region 20 formed at the front surface of the semiconductor substrate 152). A second insulating layer such as a second passivation layer 32 may be formed on at least the back surface of the semiconductor substrate 152 (more particularly, on at least the second conductivity type region 30 formed at the back surface of the semiconductor substrate 152). For example, the first and second passivation layers 22 and 32 may be in contact with the surface of the semiconductor substrate 152, and the anti-reflection layer 24 may be in contact with the first passivation layer 22. Then, the structure can be simplified. However, the embodiment of the invention is not limited thereto.

The first passivation layer 22 and the anti-reflection layer 24 may be formed on a substantially entire portion of the front surface of the semiconductor substrate 152 except for a first opening 102. Similarly, the second passivation layer 32 may be formed on a substantially entire portion of the back surface of the semiconductor substrate 152 except a second opening 104.

The first passivation layer 22 or the second passivation layer 32 is in contact with the semiconductor substrate 152 to passivate the defects existing in the surface or a bulk of the semiconductor substrate 152. Accordingly, the open-circuit voltage of the solar cell 150 can be increased by removing recombination sites of the minority carriers. The anti-reflection layer 24 reduces the reflectance of light incident to the front surface of the semiconductor substrate 152, thereby increasing the amount of light reaching the pn junction. Accordingly, the short circuit current Isc of the solar cell 150 can be increased.

The first passivation layer 22, the anti-reflection layer 24, and the second passivation layer 32 may be formed of any of various materials. For example, the first passivation layer 22, the anti-reflection layer 24, or the second passivation layer 32 may be formed of a single layer including one layer selected from a group consisting of a silicon nitride layer, a silicon nitride layer including hydrogen, a silicon oxide layer, a silicon oxynitride layer, an aluminum oxide layer, a silicon carbide layer, MgF₂, ZnS, TiO₂ and CeO₂, or a multilayer in which two or more layers selected from the above group are combined.

For example, in the embodiment, the first passivation layer 22 and/or the anti-reflection layer 24, and the second passivation layer 32 may not have a dopant or the like so as to have good insulating properties, passivation properties, and the like. However, the embodiments of the invention are not limited thereto.

The first electrode 42 may be formed by filling at least a portion of the first opening 102 and be electrically connected to (e.g., be in contact with) the first conductivity type region 20. The second electrode 44 may be formed by filling at least a portion of the second opening 104 and be electrically connected to (e.g., be in contact with) the second conductivity type region 30. The first and second electrodes 42 and 44 are made of various conductive materials (e.g., a metal) and may have various shapes.

Referring to FIG. 4, the first electrode 42 may include a plurality of finger electrodes 42a spaced apart from one another while having a uniform pitch. In FIG. 4, the finger electrodes 42a are illustrated as being arranged in parallel while being parallel to one edge of the semiconductor substrate 152. However, the embodiment of the invention is not limited to the above-described arrangement. In addition, the first electrode 42 may include bus bar electrodes 42b formed in a direction crossing the finger electrodes 42a, to connect the finger electrodes 42a. In an embodiment, one bus bar electrode 42b may be provided. Alternatively, as illustrated in FIG. 4, a plurality of bus bar electrodes 42b may be provided. In this instance, the bus bar electrodes 42b may have a greater pitch than the finger electrodes 42a. However, the embodiment of the invention is not limited to the above-described condition. For example, the bus bar electrode 42b may have a width equal to or smaller than the finger electrodes 42a.

When viewed through a cross-sectional view, all of the finger electrodes 42a and bus bar electrodes 42b of the first electrode 42 may be formed to extend through the first passivation layer 22 and anti-reflective layer 24, which is the first insulating layer. That is, the first openings 102 may be formed to correspond to the finger electrodes 42a and bus bar electrodes 42b. However, the embodiment of the invention is not limited to the above-described structures. In another embodiment, the finger electrodes 42a of the first electrode 42 may be formed to extend through the first insulating layer, and the bus bar electrodes 42b of the first electrode 42 may be formed on the first insulating layer. In this instance, the openings 102 may be formed to have a structure corresponding to that of the finger electrodes 42a, without being formed in areas where only the bus bar electrodes 42b are disposed.

The second electrode 44 may include a plurality of finger electrodes and a bus bar electrode to correspond to the plurality of finger electrodes 42a and the bus bar electrode 44a of the first electrode 42. The descriptions of the finger electrode 42a and the bus bar electrode 42b of the first electrode 42 may be applied to the finger electrode and the bus bar electrode of the second electrode 44 as they are. In this instance, the descriptions of the first passivation layer 22 and the anti-reflection layer 24 which are the first insulating film with respect to the first electrode 42 may be applied to the second passivation layer 34, which is the second insulating film with respect to the second electrode 44 as they are. The width and the pitch of the finger electrode 42a and the bus bar electrode 42b of the first electrode 42 may be the same as or be different from the width and pitch of the finger electrode and the bus bar electrode of the second electrode 44.

However, the embodiment of the invention is not limited thereto. Alternatively, the first and second electrodes 42 and 44 may have different planar structures. Other variations are possible.

As described above, in the embodiment, the first and second electrodes 42 and 44 of the solar cell 150 have a predetermined pattern so that the solar cell 150 can receive light from the front and back surfaces of the semiconductor substrate 152, and thus, the solar cell 150 has a bi-facial structure. Accordingly, the amount of light used in the solar cell 150 can be increased and thus it contributes to improving the efficiency of the solar cell 150.

In the above description, an example of the solar cell 150 has been described with reference to FIGS. 3 and 4. However, the embodiment of the invention is not limited thereto, and a structure, a type, etc., of the solar cell 150 may be variously modified. For example, the solar cell 150 may employ a photoelectric conversion unit having various structures such as using a compound semiconductor or using a dye sensitized material.

Referring to FIGS. 1 and 2, in the embodiment, a plurality of solar cells 150 may be provided, and the plurality of solar cells 150 may be electrically connected to one another in series, in parallel or in combinations thereof using the interconnectors 142. Various structures and shapes for connecting the solar cells 150 such as ribbons and wires may be applied to the interconnector 142. The embodiment of the invention is not limited to a number and so on of the interconnectors 142 used in each solar cell 150.

More specifically, the interconnectors 142 may interconnect the first electrode 42 (see FIGS. 3 and 4) formed on the front surface of one solar cell 150 and the second electrode 44 (see FIGS. 3 and 4) formed on the back surface of another adjacent solar cell 150 via a tabbing process. In the tabbing process, the interconnector 142 can be attached to the electrodes 42 and 44 of the solar cell using a solder material.

Alternatively, a conductive film may be attached between one surface of each solar cell 150 and the interconnector 142 and, thereafter, the solar cells 150 may be interconnected in series or in parallel via thermal compression. The conductive film may be formed by distributing conductive particles, such as highly conductive gold, silver, nickel, copper particles and the like, in a film formed of epoxy resin, acryl resin, polyimide resin, polycarbonate resin and the like. When heat and pressure are applied to the conductive film, the conductive particles are exposed outward of the conductive film, thus electrically connecting the solar cells 150 and the interconnectors 142 to each other. In the instance in which the solar cells 150 are interconnected into a module by the conductive film as described above, a process temperature may be lowered and, consequently, this may prevent bending of the solar cells 150.

In addition, bus ribbons 145 are used to alternately interconnect ends of the interconnectors 142 each interconnecting the solar cells 150 arranged in a single row (that is, a solar cell string). The bus ribbons 145 may be arranged at an end of each row of the solar cells 150 and be perpendicular to the solar cells 150. The bus ribbons 145 are connected to a junction box that collects electricity produced by the solar cells 150 and prevents backflow of electricity.

However, the embodiment of the invention is not limited thereto, and a connection structure between the solar cells 150, a connection structure between the solar cell 150 and an outside circuit may be variously modified. Also, the solar cell panel 100 may do not include a plurality of solar cells 150 but may be formed of one solar cell 150.

The front member 110 is located on the first sealing member 131 and constitutes a front surface of the solar panel 100 as another part of the front portion FP, and the back member 200 located on the second sealing member 132 and constitutes the back surface of the solar cell 150 as another part of the rear portion RP. In the embodiment, the rear portion RP of the solar panel 100 has transmittance to ultraviolet light, and ultraviolet light can be transmitted through the rear portion RP. In addition, the front portion FP of the solar cell panel 100 has transmittance to ultraviolet light, and ultraviolet light can be transmitted through the front portion FP.

Here, the phrase of "having transmittance to ultraviolet light" means that the transmittance of the rear portion RP or the front portion FP for light having a wavelength of 300 nm to 400 nm is 20% or more. Here, the transmittance for light having a wavelength of 300 nm to 400 nm may be based on the lowest transmittance among all the transmittances for a wavelength of 300 nm to 400 nm. When the light having a wavelength of 300 nm to 400 nm corresponding to ultraviolet light is transmitted by an amount of 20% or more for example, 20% to 100%), the light can be involved in photoelectric conversion of the solar cell 150 to improve efficiency and output of the solar cell 100. Thus, the reference of 20% is based on this. As an example, the transmittance of the rear portion RP or the front portion FP for light of a wavelength between 300 nm and 400 nm may be 20% to 80%.

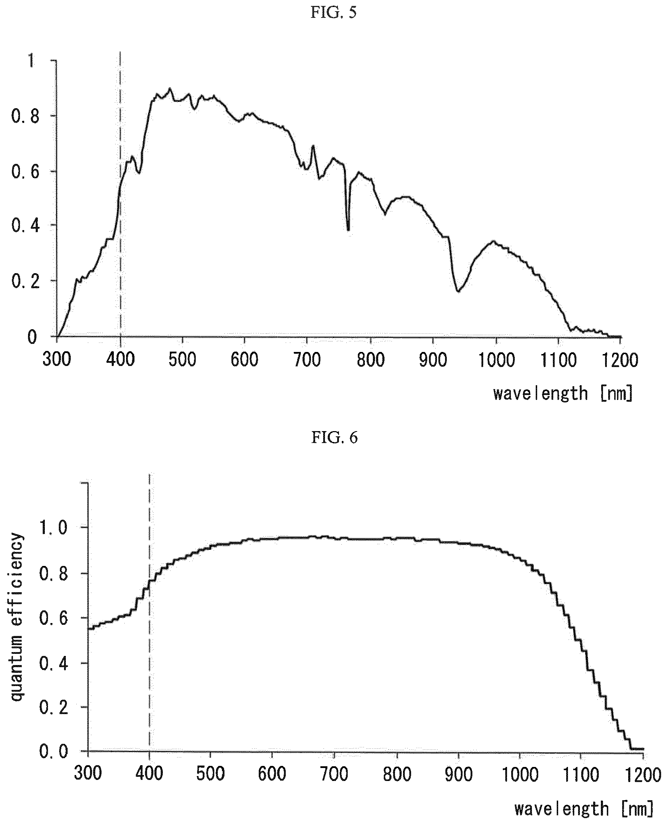

As described above, when the rear portion RP has transmittance to ultraviolet light, photoelectric conversion can further provided using light, particularly, ultraviolet light, which is incident to the back surface of the solar cell panel 100 in the solar cell panel 100 including the solar cell 150 having the bi-facial structure. Referring to FIG. 5 showing a relative value of intensity of a solar spectrum or sunlight according to a wavelength of light, it can be seen that light having a wavelength of 300 to 400 nm has an area over a certain level in a total solar spectrum area of a total solar spectrum. Referring to FIG. 6 showing a quantum efficiency of a solar cell according to a wavelength of light, it can be seen that the solar cell can cause photoelectric conversion even by light having a wavelength of 300 to 400 nm. In the embodiment, the efficiency and the output of the solar cell panel 100 can be improved by additionally using ultraviolet light which occupy an area over a certain level in the solar spectrum among lights incident on the back surface of the solar cell panel 100. In addition, the front portion FP has transmittance to ultraviolet light, and ultraviolet light incident on the front surface is also used together to maximize the photoelectric conversion.

In the embodiment, since the rear portion RP has transmittance to ultraviolet light, each of the second sealing member 132 and the rear member 200 may have transmittance to ultraviolet light. This will be explained in more detail.

In the embodiment, the rear member 200 may be formed of a resin sheet. Thus, a thickness and a weight of the solar cell panel 100 can be minimized. In this instance, the rear member 200 may be transparent. For example, the rear member 200 may have a light transmittance of 80% or more (e.g., 80% to 100%) for light in a visible light region. For example, the rear member 200 may be transparent because it does not include a separate pigment. Then, the transmittance to ultraviolet light of the rear member 200 can be enhanced more.

Here, the rear member 200 may include an ultraviolet stabilizer UVS and may not include an ultraviolet blocking agent. According to this, the rear member 200 does not include the ultraviolet blocking agent and can transmit the ultraviolet light, but can prevent the deterioration due to the ultraviolet light by including the ultraviolet stabilizer UVS.

The rear member 200 according to the embodiment includes a first resin layer 221 located on the second sealing member 132, a base member 210 located on the first resin layer 221 and having a material different from the first resin layer 221, and a second resin layer 222 located on the base member 210. A first adhesive layer 231 for bonding the first resin layer 221 to the base member 210 and a second adhesive layer 232 for bonding the base member 210 and the second resin layer 222 may be further included. However, depending on the materials and/or characteristics of the first resin layer 221 and the base member 210, the second resin layer 222 may be included or may not be included. At least one of the base member 210, and the first and second resin layers 221 and 222 may include an adhesive material, or the second resin layer 222 or the first resin layer 222 may be formed by coating on the base member 210 or the first resin layer. In this instance, the first and/or second adhesive layers 231 and/or 232 may not be provided.

First, the base member 210, the first resin layer 221, the second resin layer 222, the first adhesive layer 231 and the second adhesive layer 232 will be described in detail, and then, the ultraviolet light stabilizer UVS and the ultraviolet blocking agent will be described in detail.

The first resin layer 221 positioned on (for example, in contact with) the second sealing member 132 is a layer for adhesion with the second sealing member 132. For example, the adhesive force of the first resin layer 221 to the second sealing member 132 is higher than the adhesive force of the base member 210 and/or the second resin layer 222 (particularly, the base member 210) to the second sealing member 132. In consideration of this, the first resin layer 221 may include a fluoro polymer or a polyolefin-based material as a base material. In the specification, the term of "a base material" means a material having the most amount in wt% in each layer. The fluoro polymer will be described in detail later in the second resin layer 222. The first resin layer 221 can use the same fluorine-based material as the second resin layer 222 to improve the environmental resistance and reliability of the rear member 200. Alternatively, the first resin layer 221 may include polyethylene terephthalate (PET) or a polyolefin-based material to reduce the material cost of the rear member 200. Examples of the polyolefin-based material that can be included in the first resin layer 221 may include ethylene-vinyl acetate (EVA), polyethylene (PE), and polypropylene (PP).

The base member 210 positioned on (for example, in contact with) the first resin layer 221 serves as a base element for supporting the first resin layer 221 and/or the second resin layer 222. In addition, the base member 210 has an excellent insulating property and can improve the insulating property of the rear member 200. For this purpose, the base member 210 may have better insulating properties and have a higher mechanical strength than the first resin layer 221 and/or the second resin layer 222. For example, the base member 210 may comprise a resin, and may include, for example, a polyamide or polyester as a base material. The polyester is excellent in protecting the solar cell 150 because of its excellent mechanical properties, thermal properties, electrical characteristics, formability, chemical resistance and the like.

For example, the polyester may be a general polyester or a hydrolysis-resistant polyester (or an anti-hydrolysis polyester). In general, when the polyester is used for a long period of time, mechanical properties may be deteriorated due to hydrolysis. In view of this, a hydrolysis-resistant polyester may be used. The hydrolysis-resistant polyester may be prepared by adding various materials (for example, phosphates of an alkali metal or alkaline earth metal, inorganic ginseng salts, or the like, or suitable oligomers) to a polyester to reduce the hydrolysis ability. Alternatively, the hydrolysis-resistant polyester may be prepared by controlling a molecular weight of the polyester, or the like. In this instance, the molecular weight of the hydrolysis-resistant polyester may be approximately 8,000 to 10,000. For a base member 210 including a general polyester (molecular weight of approximately 6,000 to 8,000) or the hydrolysis-resistant polyester, variety of known films, sheets, and the like may be used.

In this instance, polyethylene terephthalate (PET) may be included as the polyester. Polyethylene terephthalate is a saturated polyester resin obtained by a condensation reaction of terephthalic acid and ethylene glycol, and is excellent in heat resistance, weather resistance, insulation, and mechanical strength. Particularly, a mold shrinkage rate is as small as about 0.1% to 0.6%, and it is possible to prevent the rear member 200 from being deformed by heat.

The base member 210 may be a sheet type or a film type made by any of various methods. However, the embodiment of the invention is not limited thereto, and the base member 210 may be manufactured by various methods.

The second resin layer 222 positioned on (for example, in contact with) the base member 210 is a layer that constitutes an outer surface of the solar cell panel 100 and has good environmental resistance (that is, stability against heat and moisture and durability against ultraviolet light). That is, the heat and moisture stability and the durability against ultraviolet light of the second resin layer 222 are higher than those of the first resin layer 221 and/or the base member 210 (particularly, the base member 210).

In consideration of this, the second resin layer 222 may include a fluoro polymer, a polyester (for example, polyethylene terephthalate), or a polyolefin-based material as a base material. In particular, the second resin layer 222 may be formed of a fluorine-based resin such as polyvinyl fluoride (PVF), polyvinylidene fluoride (PVDF), ethylene tetrafluoroethylene (ETFE) as a base resin. The fluorine-based resin is excellent in weather resistance, chemical resistance and the like since it does not have a bond that may cause hydrolysis. Particularly, polyvinylidene fluoride is a polymer having a structure of (CH₂CF₂)n and has excellent mechanical properties, weather resistance, chemical resistance and ultraviolet light resistance since it has a double fluorine molecular structure. Alternatively, the second resin layer 222 may include a polyamide-based material as a base material. Various other base materials may be used for the second resin layer 222, and the embodiment of the invention is not limited thereto.

Each of the first and second resin layers 221 and 222 and the base member 210 may be transparent. For example, the first and second resin layers 221 and 222 and the base member 210 may each have a light transmittance of 80% or more (in one example, 80% to 100%) with respect to light in a visible light region. For example, the first and second resin layers 221 and 222 and the base member 210 do not include separate pigments and may be transparent. Then, the ultraviolet transmittance of the first and second resin layers 221 and 222 and the base member 210 can be further improved. The first and second resin layers 221 and 222 may be formed on the base member 210 by coating or lamination.

The first resin layer 221 and the second resin layer 222 may be made of the same material or different materials. In this instance, the materials of the first resin layer 221 and the second resin layer 222 may be determined according to desired characteristics. For example, the first resin layer 221 may include a polyolefin-based material having a relatively low cost, and the second resin layer 222 may include a fluoro polymer having excellent environmental resistance.

In one example, the first resin layer 221 may have a thickness of 5 to 250µm. If the thickness of the first resin layer 221 is less than 5µm, the adhesion between the first resin layer 221 and the second sealing member 132 may not be excellent. If the thickness of the first resin layer 221 is greater than 250µm, the material cost may increase and the thickness of the solar cell panel 100 may be increased. The thickness of the base member 210 may be 30 to 400µm. If the thickness of the base member 210 is less than 30µm, it may be difficult to have sufficient insulation property, moisture barrier property and mechanical strength. If the thickness of the base member 210 exceeds 400µm, the handling may be inconvenient, the material cost may increase, and the thickness of the solar cell panel 100 may be thick. The thickness of the second resin layer 222 may be 0 to 60µm. The material of the second resin layer 222 is expensive due to the use of a material having excellent ultraviolet durability. Since the second resin layer 222 is not essential, it may not include the second resin layer 222, which will be described later in detail.

Alternatively, the thickness of the base member 210 may be greater than each of the thickness of the first resin layer 221 and the second resin layer 222. The thickness of the second resin layer 222 may be equal to or less than the thickness of the first resin layer 221. Then, the base member 210 has a sufficient thickness to support the rear member 200, and the material cost decreases by reducing the thickness of the second resin layer 222 having high durability by ultraviolet light and thus being relatively expensive. However, the embodiment of the invention is not limited thereto, and the thicknesses of the base member 210, the first resin layer 221, and the second resin layer 222 may be variously changed.

The first adhesive layer 231 and the second adhesive layer 232 that are positioned between the first resin layer 221 and the base member 210 or between the base member 210 and the second resin layer 222 may include an adhesive material as a base material. For example, as an adhesive material, a polyurethane-based or acrylic-based adhesive material having excellent adhesive properties and low material cost may be used. However, the embodiment of the invention is not limited thereto and various adhesive materials may be used.

The thickness of the first and/or second adhesive layers 231 an/or 232 may be smaller than that of the base member 210 serving as a base member and may be smaller than that of the first resin layer 221 and/or the second resin layer 222 (particularly, the first resin layer 221). This is because the first or second adhesive layer 231 or 232 may have only a thickness enough to have adhesive properties. In one example, the thickness of the first and/or second adhesive layers 231 and/or 232 may be between 3µm and 30µm. If the thickness of the first and/or second adhesive layers 231 and/or 232 is less than 3µm, the adhesive properties of the first and/or second adhesive layers 231 and/or 232 may be deteriorated. If the thickness of the first and/or second adhesive layers 231 and/or 232 exceeds 30µm, the thickness of the rear member 200 may be thick and the material cost may increase. However, the embodiment of the invention is not limited thereto and various modifications are possible.

However, since the base member 210, the first and second resin layers 221 and 222 may have various thicknesses as described above, the embodiment of the invention is not limited thereto. The thickness of the first and/or second adhesive layers 231 and/or 232 may be equal to or greater than the thickness of the base member 210, or the first or second resin layers 221 or 222, and so on. In one example, the rear member (or back sheet) 200, which is formed of a resin sheet, may have a thickness of from 35 to 1000µm (e.g., 100µm to 1000µm).

In the embodiment, at least one of the plurality of layers constituting the rear member 200 includes the ultraviolet stabilizer UVS, and all the layers constituting the rear member 200 do not include the ultraviolet blocking agent. That is, at least one of the base member 210, the first resin layer 221, the second resin layer 222, the first adhesive layer 231, and the second adhesive layer 232 includes the ultraviolet stabilizer UVS, while the base member 210, the first resin layer 221, the second resin layer 222, the first adhesive layer 231, and the second adhesive layer 232 constituting the rear member 200 may not include the ultraviolet blocking agent.

For example, the ultraviolet stabilizer UVS may comprise a hindered amine-based material. The hindered amine-based material can quickly stabilize radicals generated by ultraviolet irradiation, and can effectively prevent problems such as changes in properties and deterioration of the rear member 200 due to ultraviolet light.

Bis(2,2,6,6,-tetramethyl-4-piperidyl)sebacate, bis-(N-octyloxytetramethyl)piperidinyl sebacate, bis(1,2,2,6,6-pentamethyl-4-piperidyl)sebacate, methyl 1,2,2,6,6-pentamethyl-4-piperidyl sebacate, or so on may be used for the ultraviolet stabilizer UVS. However, the embodiment of the invention is not limited thereto, and the ultraviolet stabilizer UVS including any of various materials may be used.

In this instance, the ultraviolet stabilizer UVS may be included in an amount of 0.2 to 5 parts by weight based on 100 parts by weight of the layer including the ultraviolet stabilizer UVS. That is, for example, when the ultraviolet stabilizer UVS is included in the first adhesive layer 231, the ultraviolet stabilizer UVS may be included in an amount of 0.2 to 5 parts by weight based on 100 parts by weight of the first adhesive layer 231. This range is limited so that the ultraviolet stabilizer UVS can be evenly dispersed in the layer including the ultraviolet stabilizer UVS and the effect of the ultraviolet stabilizer UVS can be realized, but the embodiment of the invention is not limited thereto.

The ultraviolet blocking agent may be formed of any of various materials capable of blocking ultraviolet light. As an example, the rear member 200 (more particularly, all of the layers constituting the rear member 200) according to the embodiment may not include an ultraviolet blocking agent formed of a benzophenone-based material or a benzotriazole-based material.

In the embodiment, at least one of the first adhesive layer 231 and the second adhesive layer 232 may include the ultraviolet stabilizer UVS. That is, the base member 210, the first and second resin layers 221 and 222 do not include the adhesive material and the ultraviolet stabilizer UVS, and the first and second adhesive layers 231 and 232 are adhesive materials and at least one of the first and second adhesive layers 231 and 232 includes the ultraviolet stabilizer UVS. Thus, the properties of the first and second resin layers 221 and 222 can be prevented from deteriorating. For example, if the ultraviolet stabilizer UVS is included in the first resin layer 221 adjacent to the sealing member 130, the adhesive strength to the second sealing member 132 may be reduced, and reliability may be deteriorated. Since the second resin layer 222 located on the outer side is made of a material having excellent ultraviolet durability, it may be not necessary to include the ultraviolet stabilizer UVS separately.

The first and second adhesive layers 231 and 232 may be formed to have an adhesive mixture state and may be applied on the base member 210. The ultraviolet stabilizer UVS may be included in the rear member 200 by a simple process of adding the ultraviolet stabilizer UVS to the adhesive mixture for forming the first and second adhesive layers 231 and 232. In addition, the ultraviolet stabilizer UVS can be uniformly distributed on the first and second adhesive layer 231 or 232 formed to have a small thickness, thereby effectively preventing the problem caused by ultraviolet light.

On the other hand, since the base member 210, the first and second resin layers 221 and 222 are supplied in a form of a film or a sheet, it may be difficult to change the composition thereof. Thus, if they include the ultraviolet stabilizer UVS, the process may be complicated.

In the embodiment, the first adhesive layer 231 and the second adhesive layer 232 may have the same composition and thus have the same characteristics or properties. Then, the first adhesive layer 231 and the second adhesive layer 232 may be formed using the same mixture of an adhesive material and an ultraviolet stabilizer UVS, thereby simplifying the process and reducing the material cost. The same equipment, the same process conditions, and the like may be used to form the first adhesive layer 231 and the second adhesive layer 232 having thicknesses substantially the same (for example, within a thickness difference of 10%). Then, the process can be simplified and material costs can be reduced further. However, the embodiment of the invention is not limited thereto, and the composition and the characteristics of the first adhesive layer 231 and the second adhesive layer 232 may be different from each other.

Also, in the embodiment, both of the first and second adhesive layers 231 and 232 include an adhesive material and an ultraviolet stabilizer UVS to minimize the problem caused by ultraviolet light. However, the embodiment of the invention is not limited thereto, and the ultraviolet stabilizer UVS may be included in at least one of the first and second adhesive layers 231 and 232. For example, the first adhesive layer 231 may include an adhesive material and an ultraviolet stabilizer UVS, while the second adhesive layer 232 may include an adhesive material but not include a UV stabilizer UVS. As another example, the second adhesive layer 232 may include an adhesive material and an ultraviolet stabilizer UVS, while the first adhesive layer 231 may include an adhesive material but not include an ultraviolet stabilizer UVS. Thus, it is possible to prevent the layers at the inner side of the second adhesive layer 232 of the rear member 200 from being deteriorated by ultraviolet light.

The first and/or second adhesive layers 231 and/or 232 described above may be manufactured by any or various methods and may be used for manufacturing the rear member 200 by various methods. For example, an adhesive mixture may be prepared by mixing an adhesive material, an ultraviolet stabilizer UVS, and other additives to form the first and/or second adhesive layers 231 and/or 232. Various methods known as mixing methods may be used.

The first adhesive layer 231 is formed by applying the prepared adhesive mixture on one surface of the base member 210, and the first resin layer 221 in the form of a film or sheet is placed thereon. The base member 210 and the first resin layer 221 are adhered to each other by the first adhesive layer 231 in a lamination process where heat and pressure is applied to the stacked base member 210, the first adhesive layer 231, and the first resin layer 221. Various methods known for applying the adhesive mixture may be used. For example, if the printing method is used, the first adhesive layer 231 can be uniformly applied on one side of the base member 210, and the adhesive property can be further improved.

The second adhesive layer 232 is formed by applying the prepared adhesive mixture on the other surface of the base member 210, and the second resin layer 222 in the form of a film or sheet is placed thereon. The base member 210 and the second resin layer 222 are adhered to each other by the second adhesive layer 232 in a lamination process where heat and pressure is applied to the stacked base member 210, the second adhesive layer 232, and the second resin layer 222. Various methods known for applying the adhesive mixture may be used. For example, if the printing method is used, the first adhesive layer 231 can be uniformly applied on one side of the base member 210, and the adhesive property can be further improved.

The first resin layer 221, the first adhesive layer 231, the base member 210, the second adhesive layer 232, and the second resin layer 222 are adhered and bonded to each other to form an integral structure, thereby constituting the rear member 200. In this instance, the first resin layer 221, the first adhesive layer 231, the base member 210, the second adhesive layer 232, and the second resin layer 222 are in contact with each other to simplify the structure of the rear member 200. However, the embodiment of the invention is not limited thereto, and various modifications are possible, for example, a separate layer is disposed between the two layers.

In the above description, it is exemplified that the first resin layer 221 is bonded to the base member 210 using the first adhesive layer 231, and then the second resin layer 222 is bonded to the base member 210 using the second adhesive layer 232. However, the embodiment of the invention is not limited thereto. For example, the second resin layer 222 is bonded to the base member 210 using the second adhesive layer 232, and then the first resin layer 221 is bonded to the base member 220 using the first adhesive layer 231.

In the embodiment, a process of bonding the first resin layer 221 using the first adhesive layer 231 and a process of bonding the second resin layer 222 using the second adhesive layer 232 are separately performed. Then, the adhesion property of the first and second resin layers 221 and 222 can be improved. However, the embodiment of the invention is not limited thereto. The first and second resin layers 221 and 222 may be bonded together at the same time by forming the first and second adhesive layers 231 and 232 on both sides of the base member 210, positioning the first and second resin layers 221 and 222 thereon, and then, applying heat and pressure. Then, the manufacturing process of the rear member 200 can be simplified. Various other variations are possible.

In the embodiment, the second sealing member 132, which constitutes another part of the rear portion RP, may also have transmittance to ultraviolet light. The second sealing member 132 may include the ultraviolet stabilizer UVS without an ultraviolet blocking agent. However, the embodiment of the invention is not limited thereto. When the ultraviolet stabilizer UVS is included in the rear member 200 to prevent the problem due to ultraviolet light, the second sealing member 132 may not include the ultraviolet stabilizer UVS.

The second sealing member 132 prevents moisture and oxygen from entering and chemically combines the elements of the solar cell panel 100. The second sealing member 132 may include an insulating material having translucency and adhesion as a base material, and may further include the ultraviolet stabilizer UVS. For example, the second sealing member 132 may be formed of an ethylene vinyl acetate resin (EVA), a polyvinyl butyral, a silicone resin, an ester resin, an olefin resin, a polyethylene resin, an ionomer, or so on. As the ultraviolet stabilizer, the description of the ultraviolet stabilizer described in the rear member 200 may be applied as it is.

For example, the ultraviolet stabilizer UVS may be included in an amount of 0.2 to 5 parts by weight based on 100 parts by weight of a total amount of the second sealing member 132. This range is limited so that the ultraviolet stabilizer UVS can be evenly dispersed in the second sealing member 132 and the effect of the ultraviolet stabilizer UVS can be realized, but the embodiment of the invention is not limited thereto.

The second sealing member 132 may be transparent. For example, the second sealing member 132 may have a light transmittance of 80% or more (e.g., 80% to 100%) for light in a visible light region. For example, the second sealing member 132 may be transparent because it does not include a separate pigment. Then, the transmittance to ultraviolet light of the second sealing member 132 can be further enhanced.

In the embodiment, the front portion FP may also have transmittance to ultraviolet light. That is, transmittance of the front portion FP for light having a wavelength of 300 nm to 400 nm is 20% or more. For the same, both of the front member 110 and the first sealing member 131 constituting the front portion FP may have transmittance to ultraviolet light.

The front member 110 and the first sealing member 131 may be transparent. For example, the front member 110 and the first sealing member 131 may have a light transmittance of 80% or more (e.g., 80% to 100%) for light in a visible light region. For example, the front member 110 and the first sealing member 131 may be transparent because they do not include a separate pigment. Then, the transmittance to ultraviolet light of the front portion FP can be enhanced more.

In one example, the front member 110 may include a glass substrate. Then, the front member 110 can have transmittance to ultraviolet light due to high light transmittance or transparency of the glass substrate. When the front member 110 is formed of a glass substrate, the solar cell 150 can be protected with excellent light transmittance, durability, and insulation characteristics. By using the front member 110 formed of the glass substrate and the rear member 200 formed of a resin sheet (that is, a back sheet), a thickness and weight of the solar cell panel 100 can be reduced while improving the durability.

As the first sealing member 131, the base material included in the second sealing member 132 may be used as it is, and thus, a detailed description will be omitted. The first sealing member 131 may include an ultraviolet stabilizer UVS and may not include an ultraviolet blocking agent, like the second sealing member 132. Thus, problems caused by ultraviolet light can be minimized. For example, the first sealing member 131 and the second sealing member 132 may be formed of the same material. However, the embodiment of the invention is not limited thereto, and the first sealing member 131 may not include the ultraviolet stabilizer UVS, or the first sealing member 131 may be formed of a material different from the second sealing member 132.

The solar cell panel 100 according to the embodiment may be formed by integrating the rear member 200, the second sealing member 132, the solar cell 150, the first sealing member 131, and the front member 110 through using a lamination process or so on.

In the embodiment, the rear portion RP has transmittance to ultraviolet light, ultraviolet light incident on the back surface of the solar cell 150 can be used for photoelectric conversion when the solar cell 150 has the bi-facial structure. Thereby, the rear portion RP does not include the ultraviolet blocking agent. Instead, at least one of the plurality of layers constituting the rear portion RP may include the ultraviolet stabilizer UVS to minimize or prevent problems caused by ultraviolet light.

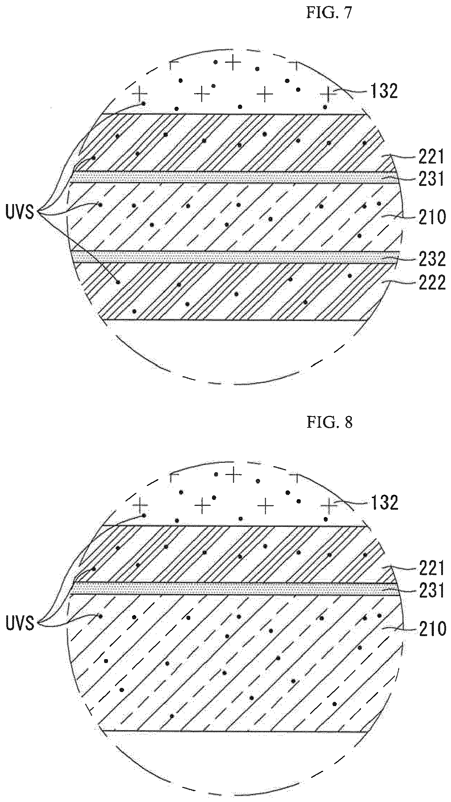

In the above-described embodiment, it is exemplified that the ultraviolet stabilizers UVS are included in the second sealing 132 and the first and second adhesive layers 231 and 232 among the various layers of the rear member 200. However, the embodiment of the invention is not limited thereto and various modifications are possible. Hereinafter, a solar cell panel according to other embodiments of the invention will be described in detail with reference to FIGS. 7 to 11. For simplicity and clarity, only a portion corresponding to an enlargement circle in FIG. 2 is shown in FIGS. 7 to 11. Hereinafter, the same or similar portions as those of the above-described embodiment may be applied to the following embodiments, and thus detailed description thereof will be omitted. Thus, only different portions will be described in detail. It is also within the scope of the invention to combine the above-described embodiment or variations thereof with the following embodiments or modifications thereof.

FIG. 7 is a partial expended view of a part of a solar cell panel according to another embodiment of the invention.

Referring to FIG. 7, in the embodiment, a base member 210 and first and second resin layers 221 and 222 each include an ultraviolet stabilizer UVS. The ultraviolet stabilizers UVS are included in layers having relatively thick thicknesses so that the ultraviolet stabilizers UVS are contained in a sufficient amount to minimize the problem of ultraviolet transmission. As a modified embodiment, the first and second adhesive layers 231 and 232 may not be included. Alternatively, at least one of the first and second adhesive layers 231 and 232 may further include the ultraviolet stabilizer UVS.

FIG. 8 is a partial expended view of a part of a solar cell panel according to yet another embodiment of the invention.

Referring to FIG. 8, in the embodiment, a base member 210 and a first resin layer 221 each include an ultraviolet stabilizer UVS. A second resin layer 222 (see FIG. 7) is not included, and thus, the base member 210 may constitute an outer surface of a rear member 200 or a solar cell panel 100. Since the base member 210 and the first resin layer 221 have superior ultraviolet durability, the second resin layer 222 for improving ultraviolet durability can be omitted, thereby simplifying a structure and reducing a material cost. As a modified embodiment, the first adhesive layer 231 may be not included. Alternatively, the first adhesive layer 231 may further include an ultraviolet stabilizer UVS.

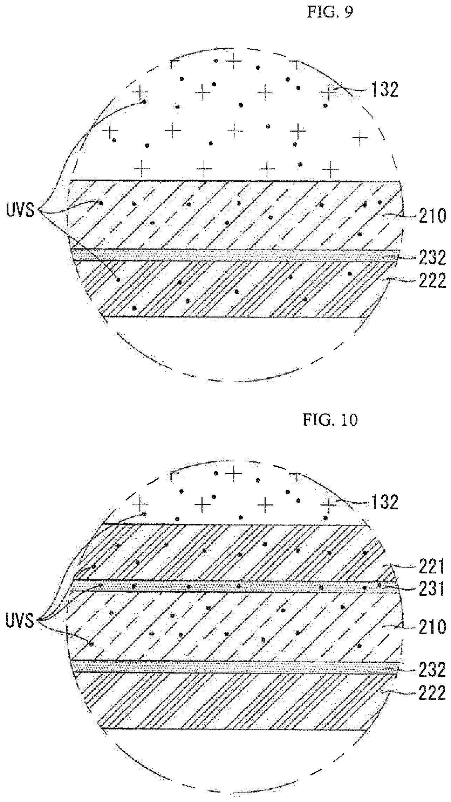

FIG. 9 is a partial expended view of a part of a solar cell panel according to yet still another embodiment of the invention.

Referring to FIG. 9, in the embodiment, a rear member includes a base member 210 and a second resin layer 222 positioned at an outside, and a first resin layer 221 (see FIG. 7) is not included. According to this, the rear member 220 can have a simple structure. In this instance, a second adhesive layer 232 is provided between the base member 210 and the second resin layer 222, and a first adhesive layer 231 (see FIG. 7). However, the embodiment of the invention is not limited thereto, and an first adhesive layer 231 may be provided on a surface of the rear member 220 adjacent to a second sealing member 132 (on a surface of the base member 210 adjacent to the second sealing member 132) may be separately provided. Further, the first and second adhesive layers 231 and 232 may be omitted. Various other variations are possible.

In FIG. 9, it is exemplified that the base member 210 and the second resin layer 222 each include the ultraviolet stabilizer UVS. However, the embodiment of the invention is not limited thereto. Thus, one of the base member 210 and the second resin layer 222 may not include the ultraviolet stabilizer UVS. As another example, the first adhesive layer 231 may further include the ultraviolet stabilizer UVS. That is, at least one of the base member 210, the second resin layer 222, and the second adhesive layer 232 includes the ultraviolet stabilizer UVS, and all of the base member 210, the second resin layer 222, and the second adhesive layer 232 do not include an ultraviolet blocking agent.

FIG. 10 is a partial expended view of a part of a solar cell panel according to yet still another embodiment of the invention.

Referring to FIG. 10, in the embodiment, each of a base member 210, a first adhesive layer 231, and a first resin layer 221 includes an ultraviolet stabilizer UVS.

At least one of the plurality of layers constituting the rear member 200 may comprise the ultraviolet stabilizer UVS. That is, the embodiment of the invention is not limited to which layer among the plurality of layers constituting the rear member 200 includes the ultraviolet stabilizer UVS. When the ultraviolet stabilizer UVS is included in each of the plurality of layers constituting the rear member 200, the plurality of layers may comprise the same ultraviolet stabilizer UVS or the different ultraviolet stabilizers UVS.

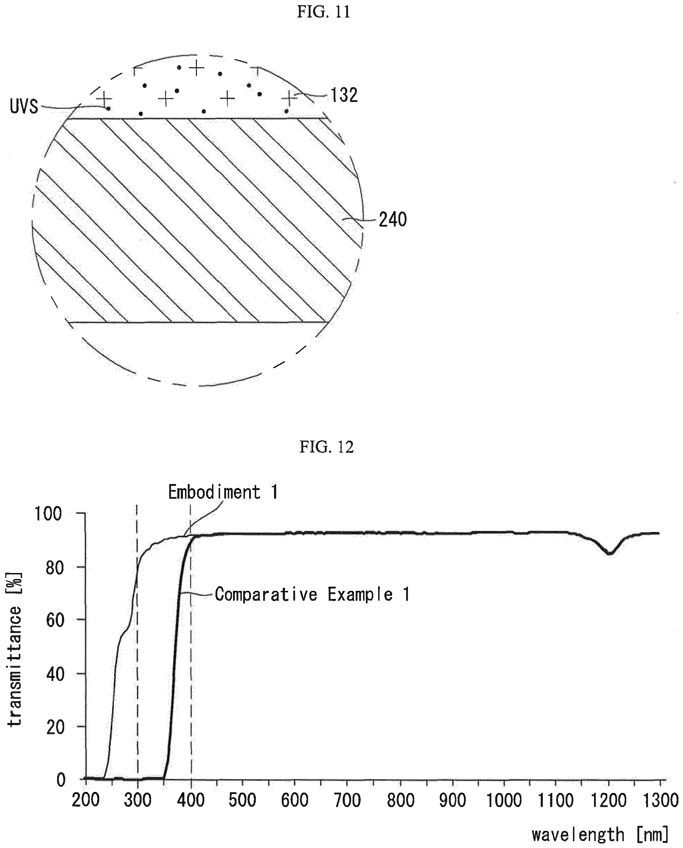

FIG. 11 is a partial expended view of a part of a solar cell panel according to yet still another embodiment of the invention.

Referring to FIG. 11, in the embodiment, a rear member 200 may be formed of a glass substrate (for example, a single glass substrate). When the rear member 200 includes the glass substrate, the rear member 200 may also have transmittance to ultraviolet light due to the high light transmittance or transparency of the glass substrate. When the rear member 200 is formed of a glass substrate, the solar cell 150 can be protected with high transparency, durability and insulation characteristics. In this instance, the second sealing member 132 may include the ultraviolet stabilizer in order to prevent the problem due to ultraviolet light.

Hereinafter, the invention will be described in more detail with reference to experimental examples of the invention. However, the experimental examples of the inventions just examples of the invention, and thus, the invention is not limited thereto.

### Embodiment 1

A solar cell panel was manufactured by integrating a rear member, a second sealing member, a bi-facial solar cell, a first sealing member, and a front member by a lamination process. In this instance, the first and second sealing members include ethylene vinyl acetate as a base material, and further include 1 part by weight of bis (2,2,6,6-tetramethyl-4-piperidyl) sebacate as an ultraviolet stabilizer. The rear member was manufactured by attaching a first resin layer including polyamide as a base material and a second resin layer including floro polymer as a base material to a base member including polyethylene terephthalate as a base material through using first and second adhesive layers, each including an acrylic adhesive material as a base material and including 1 part by weight of bis (2,2,6,6-tetramethyl-4-piperidyl) sebacate as an ultraviolet stabilizer. In this instance, the rear member did not contain a separate pigment.

### Comparative Example 1

### A solar cell panel was manufactured by a method the same as the method as in Embodiment 1 except that first and second sealing members and a rear member did not include an ultraviolet stabilizer and the rear member included an ultraviolet blocking agent and a white pigment.

Transmittances of the rear portions according to Embodiment 1 and Comparative Example 1 were measured and the results are shown in FIG. 12. Also, a rear output, a rear power amount, and a total power amount in Embodiment 1 and Comparative Example 1 were measured. In Table 1, values of Comparative Example 1 were set as 100%, and relative values were described for values of Example 1. In this instance, a plurality of solar cell panels according to Embodiment 1 were manufactured and measured, and a plurality of solar cell panels according to Comparative Example 1 were manufactured and measured. In Table 1, an average value of a plurality of solar cell panels was described for Comparative Example 1, a range of values of a plurality of solar cells were described for Embodiment 1. Here, the rear output and the rear power amount were measured in a state in which light is not incident on the front portion but only light is incident on the rear portion, and the total power amount is measured in a state in which light is incident on the front portion and the rear portion.

**[Table 1]**

| | Embodiment 1 | Comparative Example 1 |
|---|---|---|
| Rear output [%] | 101∼103 | 100 |
| Rear Power Amount [%] | 101∼103 | 100 |
| Total Power Amount [%] | 100.5∼102 | 100 |

Referring to FIG. 12, the transmittance (the lowest transmittance) of the rear portion to light having a wavelength of 300nm to 400nm is extremely high as 80% or more in Embodiment 1, while the transmittance (the lowest transmittance) of the rear portion to light having a wavelength of 300nm to 400nm is very low as about 0% in Comparative Example 1.

Referring to Table 1, it can be seen that the solar cell panel according to Embodiment 1 has the rear output, the rear power amount, and the total rear power amount greater than those of the solar cell panel according to Comparative Example 1. According to this, it can be seen that the output and efficiency of the solar cell panel can be improved by using the rear portion having the transmittance to ultraviolet light to the solar cell panel including the solar cell having the bi-facial structure.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A solar cell panel, comprising:
a bi-facial solar cell;
a front portion positioned on a front surface of the bi-facial solar cell; and
a rear portion positioned on a back surface of the bi-facial solar cell,
wherein the rear portion has transmittance to ultraviolet light.

2. The solar cell panel of claim 1, wherein the transmittance of the rear portion for ultraviolet light having a wavelength of 300 nm to 400 nm is 20% or more.

3. The solar cell panel of claim 1 or 2, wherein the front portion comprises a front member positioned on the front surface of the bi-facial solar cell and a first sealing member disposed between the bi-facial solar cell and the front member,
wherein the rear portion includes a rear member positioned on the back surface of the bi-facial solar cell and a second sealing member positioned between the bi-facial solar cell and the rear member, and
wherein each of the second sealing member and the rear member has transmittance to ultraviolet light.

4. The solar cell panel of claim 3, wherein the rear member is formed of a resin sheet or a glass substrate.

5. The solar cell panel of claim 3 or 4, wherein the rear member is formed of the resin sheet, and
wherein the resin sheet includes the ultraviolet stabilizer and does not include the ultraviolet blocking agent.

6. The solar cell panel of any one of claims 3 to 5, wherein the rear member includes a hindered amine-based material as an ultraviolet stabilizer, and does not include a benzophenone-based material or a benzotriazole-based material as an ultraviolet blocking agent.

7. The solar cell panel of any one of claims 3 to 6, wherein the rear member includes at least one of bis(2,2,6,6,-tetramethyl-4-piperidyl)sebacate, bis-(N-octyloxytetramethyl)piperidinyl sebacate, bis(1,2,2,6,6-pentamethyl-4-piperidyl)sebacate, and methyl 1,2,2,6,6-pentamethyl-4-piperidyl sebacate as the ultraviolet stabilizer.

8. The solar cell panel of any one of claims 5 to 7, wherein the rear member comprises a plurality of layers,
wherein at least one of the plurality of layers includes the ultraviolet stabilizer, and
wherein all of the plurality of layers do not include the ultraviolet blocking agent.

9. The solar cell panel of claim any one of claims 5 to 8, wherein the rear member comprises a base member, a resin layer formed on the base member, and an adhesive layer positioned between the base member and the resin layer to adhere the base member and the resin layer, and
wherein the adhesive layer includes the ultraviolet stabilizer, or the resin layer does not include the ultraviolet stabilizer.

10. The solar cell panel of claim 8 or 9, wherein the ultraviolet stabilizer is included in an amount of 0.2 to 5 parts by weight based on 100 parts by weight of the at least one layer of the plurality of layers of the rear member including the ultraviolet stabilizer.

11. The solar cell panel of any one of claims 3 to 11, wherein at least one of the following is fulfilled;
wherein the second sealing member includes an ultraviolet stabilizer and does not include an ultraviolet blocking agent;
wherein the front member is formed of a glass substrate; and
wherein the first sealing member includes an ultraviolet stabilizer and does not include an ultraviolet blocking agent.

12. The solar cell panel of any one of claims 1 to 11, wherein the front portion has transmittance to ultraviolet light.

13. A back sheet for a solar cell panel, wherein the back sheet includes a resin and has transmittance to ultraviolet light.

14. The back sheet for the solar cell panel of claim 13, wherein the back sheet comprises a plurality of layers,
wherein at least one of the plurality of layers includes an ultraviolet stabilizer, and
wherein all of the plurality of layers do not include an ultraviolet blocking agent.

15. The back sheet for the solar cell panel of claim 13 or 14, wherein the back sheet comprises a base member, a resin layer including the resin and formed on the base member, and an adhesive layer positioned between the base member and the resin layer to adhere the base member and the resin layer, and
wherein the adhesive layer includes the ultraviolet stabilizer.
